# EUROPEAN PATENT SPECIFICATION

(11) **EP 0 326 571 B1**
(45) Date of publication and mention of the grant of the patent: **07.04.1993**
(21) Application number: 87906696.7
(22) Date of filing: 09.09.1987
(51) Int. Cl.: H05K 3/04, B29C 65/60, B29C 65/64, B29C 69/00, H05K 3/46, H01H 11/06, H01R 9/16

(54) **METHOD AND APPARATUS FOR PRODUCING A STAMPED SUBSTRATE**
VORRICHTUNG UND VERFAHREN ZUR HERSTELLUNG EINES GESTEMPELTEN SUBSTRATS
PROCEDE ET APPAREIL DE PRODUCTION D'UN SUBSTRAT ESTAMPE

(30) Priority: 27.10.1986 US 923807
(43) Date of publication of application: 09.08.1989
(73) Proprietor: Black & Decker Inc., Newark Delaware 19711 (US)
(72) Inventor: WHEELER, Dale, K., Fallston, MD 21047 (US)
(74) Representative: Lucas, Brian Ronald
(86) International application number: US8702300
(87) International publication number: WO8803356

(56) References cited:
- BE-A- 723 315
- CH-A- 361 553
- DE-A- 1 920 061
- DE-A- 2 934 869
- FR-A- 687 094
- FR-A- 2 291 600
- GB-A- 661 989
- GB-A- 989 471
- GB-A- 2 072 059
- US-A- 2 938 939
- US-A- 3 464 051
- US-A- 3 945 808
- MACHINE DESIGN, vol. 37, no. 4, 18 February 1965; W.J. Ehner: "Metal/plastic assemblies", pages 183 - 185

## Description

### TECHNICAL FIELD

This invention relates to the field of stamped substrates, particularly to the fabrication and attachment of conductors to substrates which may then be used in a power distribution system for circuit board assemblies.

### BACKGROUND ART

Appliances and other articles often use power distribution systems to deliver electrical power from power cords to the electrical components in the appliance. To accommodate the relatively high wattage which the power distribution systems carry, the conductors in such power distribution systems have to be relatively large. Because of the conductor size, assembly of such power distribution systems are often performed manually.

There are several problems associated with manual assembly of power distribution systems. First, the cost of manually assembling the power distribution systems is often as much as 20 to 30% of the total assembly cost. In addition, manual assembly of power distribution systems occasionally results in premature failure due to open or intermittent connections formed during assembly. For these reasons, it is desirable to automate as much of the assembly as possible.

One technique for automatic assembly of circuit board patterns is shown in Us Patent No. 2,971,249. This patent discloses a three-step process for depositing conductive patterns on substrates. A die-blanking press is used to form and deposit a conductive pattern on a base material. The die-blanking operation is followed by a punching operation and a molding operation. The conductive pattern is bonded by an adhesive material deposited on the substrate or by using a separate molding operation.

In FR-A-687 094 there is disclosed a method of laying metal leaf, e.g. copper leaf, on the surface of an insulating panel, and then punching a selected portion from the metal leaf, this punching step also being operable to effect insertion of the periphery of the selected portion into the insulating panel to effect interengagement therebetween. To further secure the punched portion of the conductor in position, mastic may be applied in a depression between the periphery of the punched conductor and the immediately surrounding portion of the insulating member.

In Fr-A-2 291 600 a matrix of electrical conductors, temporarily connected together by a surrounding integral peripheral portion, is Superimposed on a plate of insulating material. The individual conductors may be mechanically secured to the insulating plate by folded lugs of the conductors engaging through the insulating plate, and studs on the plate engaging through holes in the conductors and being hot snapped by heating punches.

### DISCLOSURE OF THE INVENTION

An object of the present invention is to provide an improved method of forming a selected portion from a planar member and attaching this selected portion to a substrate.

Accordingly, therefore, there is provided by the present invention a method of making at least a part of an electrical or electronical circuit, comprising the steps of locating a planar member of electrically conducting material proximate a substrate of electrically insulating material, and punching the planar member to form a selected portion therefrom, the punching step also being operable to effect interengagement between parts of said selected portion and the substrate, characterized in that: said locating step comprises situating the planar member between a punch and a die plate with the die plate being disposed between the planar member and the substrate; said punching step includes passing said punch through said planar member and into said die plate to punch said selected portion from said planar member and deposit said selected portion through said die plate onto said substrate with said interengagement between said parts occurring; and said punching step also includes, subsequent to said interengagement between said parts having occurred, mechanically deforming at least one of the previously interengaged parts to positively secure said parts together.

The substrate may include a projection, the step of punching the planar member being operable to cause deformation of said projection thereby securing the selected portion to the substrate.

The step of punching the planar member may include the step of embedding a region of the selected portion into said substrate.

The step of punching the planar member may include the step of forcing a region of the selected portion through an aperture in the substrate thereby securing the selected portion to the substrate. The step of punching the substrate may also include an additional step of deforming this region of the selected portion after this region is inserted through the aperture in the substrate

The substrate may have at least one rib, and the step of punching the planar member may be operable to deform this rib and create the mechanical interengagement between this rib and the selected portion.

The step of punching the planar member may include the sub-steps of forming a lance on the selected portion and inserting this lance into an aperture in the substrate thereby creating the mechanical interengagement between this lance and the substrate. Further, a portion of this lance may be forced against a support supporting said substrate thereby causing the lance to deform.

It is yet a further object of the invention to provide other electrical assemblies utilizing the above method.

There is provided, therefore, by another aspect of the present invention a terminal assembly for connecting at least one lead from an electrical component to a power distribution system, said terminal assembly being attached to a substrate by the foregoing method and being characterized by an electrical conductor having a grooved portion operable to receive said lead; the substrate mechanically communicating with the electrical conductor; and means for securing the electrical conductor to the substrate, the securing means comprising a portion of the substrate and at least a part of the conductor interengaged with mechanical interference therebetween.

There is also provided by a further aspect of the present invention a multilayer power distribution system, characterized by a first substrate layer; a first conductor layer mechanically communicating with the first substrate layer; a second substrate layer mechanically communicating with the first conductor layer; and a second conductor layer having projections extending through the second substrate layer, the projections permitting electrical communication between the first and second conductor layers with the second conductor layer having been attached to the second substrate layer by the foregoing method.

According to yet a further aspect of the present invention, there is provided an electrical switch, characterized by a first electrical conductor formed from a sheet of conductive material during a punching operation and displaceable into contact with said first electrical conductor to close said electrical switch; a second electrical conductor formed from the sheet of conductive material during this punching operation; a substrate to which the first and second electrical conductors are attached; and the electrical conductors being attached to the substrate by the foregoing method with the formation of mechanical interengagement between the substrate and each of the electrical conductors.

According to yet another aspect of the present invention, there is provided a heat sink of an electronic module, characterized by a thermally conductive member being formed from a planar member during a punching operation; a substrate mechanically communicating with the thermally conductive member; means for attaching the conductive member to the substrate with mechanical interengagement between the thermally conductive member and the substrate; and the thermally conductive member having been formed and attached to the substrate by the foregoing method.

Other objects, features and advantages of the present invention will become more fully apparent from the following detailed description of the preferred embodiments, the appended claims and the accompanying drawings.

### BRIEF DESCRIPTION OF THE DRAWINGS

In the accompanying drawings, in which the same reference characters in different Figures indicate like parts:
- FIG. 1: illustrates an apparatus for forming stamped substrates according to the present invention;
- FIG. 2: is a cross-sectional view of the apparatus for forming stamped substrates taken on the line 2-2 of Fig. 1:
- FIGS.3(a) to 3(l): illustrate various manners in which a conductor can be secured to a substrate according to the present invention using the apparatus shown in Fig. 1, Fig. 3(e) being a partial section on the line 3(e)-3(e) of Fig. 3(d);
- FIGS.4(a), 4(b) and 4(c): illustrate the manner in which vertically oriented conductor projections can be formed and secured according to the invention using the apparatus shown in Fig. 1;
- Fig. 5: illustrates a multilayer circuit board which may be formed according to the invention using the apparatus shown in Fig. 1;
- FIGS. 6(a) to 6(d): illustrate the manner in which a component with an axial lead is connected to a stamped substrate formed by using the apparatus shown in Fig. 1;
- FIGS. 7(a) to 7(e): illustrate the manner in which the apparatus shown in Fig. 1 may be used to form switches on a stamped substrate;
- FIG. 8: illustrates a heat sink which is formed by the apparatus shown in Fig. 1;
- FIGS.9(a) and 9(b): illustrate a molded cordset connector block which may be formed in part by the apparatus shown in Fig. 1, Fig. 9(b) being a side view of Fig. 9(a) taken on the line 9(b)-9(b) thereof; and
- FIGS.10(a) and 10(b): illustrate a power distribution system which is formed according to the invention using the apparatus of Fig. 1.

### BEST MODES FOR CARRYING OUT THE INVENTION

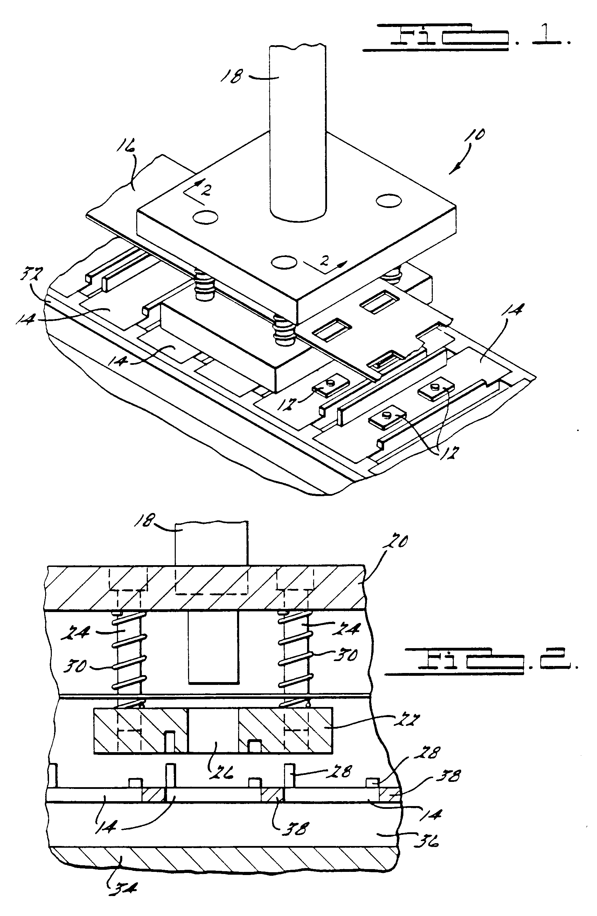

Referring to Fig. 1, an apparatus 10 is shown for depositing the conductors 12 on the substrates 14 according to the present invention. The substrates 14 may be formed from molded plastic, stamped fiberboard, or sheet plastic extrusion, though it is to be understood other materials may be used. The apparatus 10 receives a carrier strip 16 from which the conductors 12 are formed. The carrier strip 16 is a planar member fabricated from copper, brass, bronze, aluminum, or other suitable materials.

To form the conductors 12 from the carrier strip 16, the apparatus 10 includes a punch 18 which sequentially blanks the carrier strip 16 thereby forming the conductor 12. Once the conductors 12 are formed by the punch 18 during the blanking operation, the punch 18 deposits the conductors 12 onto the substrates 14. The conductors 12 are secured to the substrate 14 by mechanical interference between the conductors 12 and the substrates 14 in the manner described below. To support the punch 18, the apparatus 10 includes a punch plate 20 and a die plate 22. The punch plate 20 is vertically disposed over the die plate 22 and is connected by a plurality of posts 24. The posts 24 insure that the geometric relationship between the punch plate 20 and the die plate 22 is maintained. The die plate 22 floats on the posts 24 so that the die plate 22 will not interfere with the projections 28 on the substrate 14 during the indexing operation described below. To permit separation of the punch plate 20 from the die plate 22 during the upward stroke of the punch 18, a plurality of springs 30 are provided. The springs 30 are used to bias the position of the punch plate 20 in a direction opposing the die plate 22.

To deliver substrates 14 to the apparatus 10, an indexing mechanism 32 is provided. The indexing mechanism 32 includes a base portion 34 and a movable member 36 with a plurality of lateral members 38. The indexing mechanism 32 sequentially delivers the substrate 14 to a position below the punch 18 by movement of the lateral members 38.

After the punch 18 blanks and deposits the conductors 12 on a particular substrate 14, the lateral member 38 moves a new substrate 14 into position underneath the punch 18.

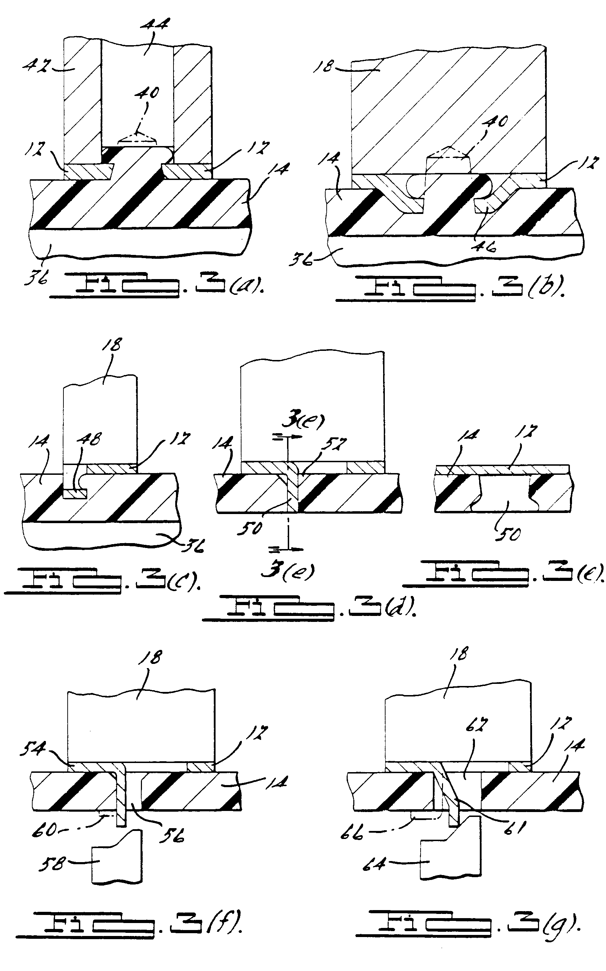

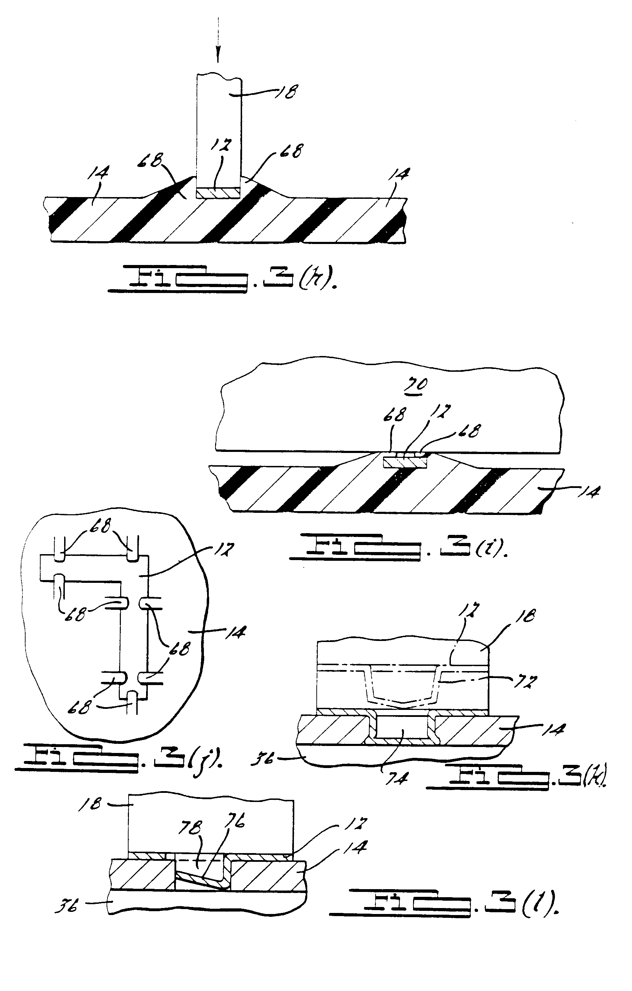

Several means for securing conductors 12 to the substrates 14 may be used. As shown in Fig. 3(a), the substrate 14 has a projection 40 which is initially able to pass through an aperture in the conductor 12. After the conductor 12 has been deposited on to the substrate 14 by a first portion 42 of the punch 18, a second portion 44 of the punch 18 deforms the projection 40 into a bead. The mechanical interference between the projection 40 and the conductor 12 prevents the removal of the conductor 12 from the substrate 14. In Fig. 3(b), the substrate 14 includes a depressed area 46 having a centrally located projection 40. To secure the conductor 12, the punch 18 deforms the projection 40 causing the projection 40 to form a bead within the depressed area 46. The mechanical interference between the projection 40 and the conductor 12 secures the conductor 12 to the substrate 14. By causing the projection 40 to deform in this manner, the possibility that the projection 40 will interfere with subsequent operations is minimized as the projection 40 is located below the surface of the conductor 12.

Another means for securing the conductor 12 to the substrate 14 is shown in Fig. 3(c). After the conductor 12 is blanked as described above, the punch 18 lances a portion 48 of the conductor 12 into the substrate 14. The material from which the substrate 14 is made then flows into the region of the substrate 14 which is lanced thereby securing the conductor 12 to the substrate 14. In Fig. 3(d), the punch 18 forces a portion 50 of the conductor 12 through an aperture 52 in the substrate 14. Then the end of the portion 50 is then deformed as shown in Fig. 3(e). In Fig. 3(f), the punch 18 is used to force a portion 54 of the conductor through an aperture 56 in the substrate 14. A roll set 58 is then used to deform a region 60 of the portion 54 of the conductor 12 so as to secure the conductor 12 to the substrate 14. A similar means for securing the conductor 12 to the substrate 14 is shown in Fig. 3(g), in which the punch 18 forces a portion 61 of the conductor 12 through an aperture 62 in the substrate. The roll set 64 is then used to deform a region 66 of the portion 61 of the conductor 12 to secure the conductor 12 to the substrate 14.

Further means for securing the conductor 12 to a substrate 14 is shown in Figs. 3(h) to 3(j). The substrate 14 is formed with a plurality of ribs 68 which are able to receive the conductor 12. The conductor 12 is blanked from the carrier strip 16 and then deposited on the substrate 14 between the ribs 68. A second punch 70 is then used to cold stake the ribs 68. The mechanical interference between the ribs and the conductor 12 thereby secures the conductor 12 to the substrate 14.

Additional means for securing the conductor 12 to the substrate 14 is shown in Figs. 3(k) to 3(l). In Fig. 3(k), the punch 18 initially forms a lance 72 on the conductor which is able to be inserted into an aperture 74 in the substrate. As the tip of the lance 72 reaches the movable member 36 during insertion, the edges of the lance 72 are forced against the sides of the aperture 74, thereby mechanically securing the conductor 12 to the substrate 14. As shown in Fig. 3(l), the punch 18 initially forms a finger trapping lance 76 on the conductor 12. The finger trapping lance 76 is then forced into the aperture 78 in the substrate 14 so as to mechanically interfere with the substrate 14. While several means for forming and securing the conductor 12 to the substrate 14 by mechanical interference are shown, other suitable techniques may be used.

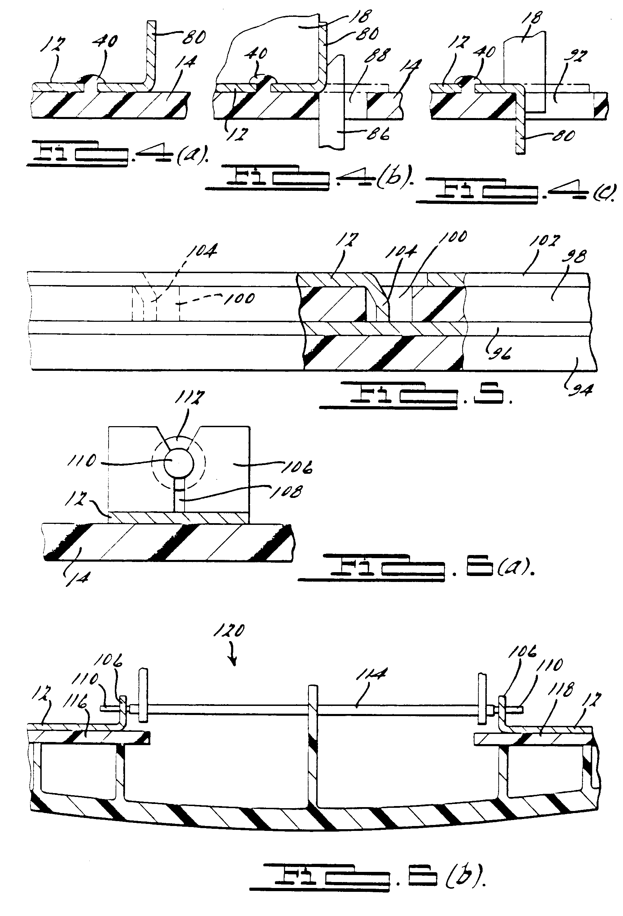

The apparatus 10 may be used to form and attach vertical conductor projections to the substrate 14. As shown in Fig. 4(a), a conductor 12 having a projection 80 is formed during the blanking operation. The projection 80 is then secured to the substrate 14 in the manner as discussed above. The apparatus 10 may also be used to form the conductor 12 having the projections 80 in the manner shown in Fig. 4(b), in which a form punch 86 is displaced vertically through an aperture 88 in the substrate 14 to cause the projection 80 to form against the punch 18. Alternatively, the punch 18 may force the projection 80 of the conductor 12 through an aperture 92 in the substrate 14 as shown in Fig. 4(c). While several means for forming and securing vertical conductor projections to substrates have been described above, it will be under stood that other suitable means may also be used.

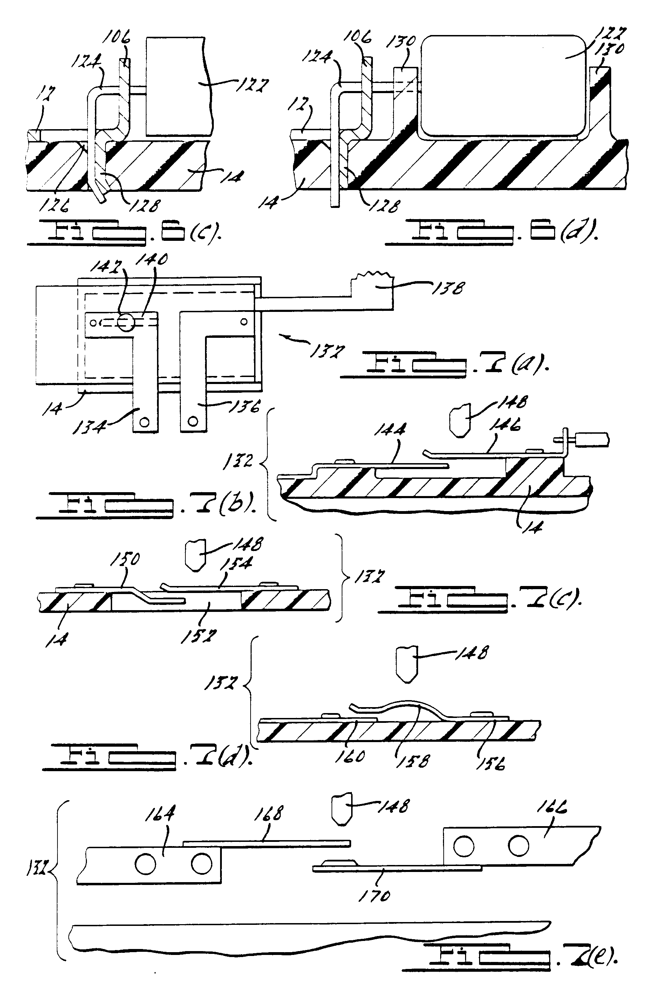

The apparatus 10 may also be used to form multilayer circuit boards. As shown in Fig. 5, a substrate 94 is provided to which a first conductor layer 96 is attached.

An insulator layer 98 having a plurality of apertures 100 is then secured to the conductor layer 96, upon which a second conductive layer 102 is attached. The second conductive layer 102 has a plurality of projections 104 which are able to extend through the apertures 100 in the insulator layer 98 and electrically communicate with the first conductor layer 96. Accordingly, electrical power may be delivered from the first conductor layer 96 to the second conductive layer 102 through the projections 104.

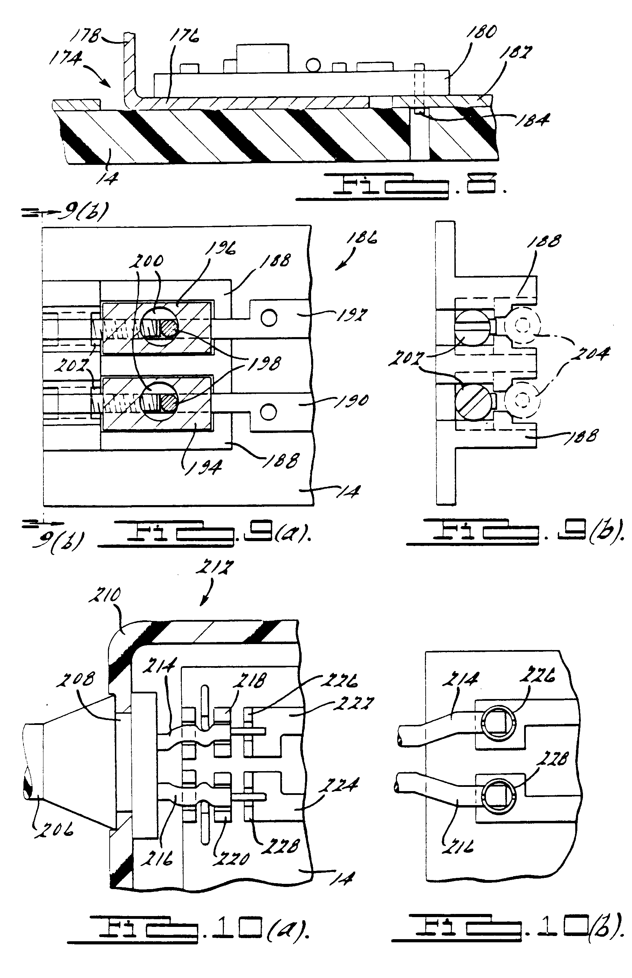

The apparatus 10 may also be used to form and secure component terminals to the substrates 14 as shown in Figs. 6(a) to (d). A component terminal 106 is blanked to include a groove 108 for accommodating a lead 110 from a component 112. The component terminal 106 is then secured to the substrate 14 by mechanical interference in the manner described above. The component terminals 106 may be used for securing a wire 114 between two portions 116 and 118 of an electrical assembly 120 as shown in Fig. 6(b). The component terminals 106 may also be used for mechanical surface mounting an electrical component 122 as shown in Fig. 6(c), in which the lead 124 from a component 122 passes through an aperture 126 in the substrate 14 in which a portion 128 of the component terminal 106 is disposed. The end of the lead 124 is then bent to physically secure the component 122 to the substrate 14 as well as to provide for additional electrical connection. The substrate 14 may also include projections 130 which further secure the component 122 to the substrate as shown in Fig. 6(d).

The apparatus 10 can also be used to form a variety of switches 132 as shown in Figs. 7(a) to (e). In Fig. 7(a), two stationary contacts 134 and 136 are formed and secured to a substrate 14 by mechanical interference in the manner described above. An actuator 138 is provided which mechanically communicates with a movable contact 140. The movable contact 140 is biased in a direction toward the stationary contact 134 by a spring 142. When the actuator 138 is laterally moved, the movable contact 140 mechanically communicates with both of the stationary contacts 134 and 136 thereby providing electrical communication therebetween. In Fig. 7(b), two conductors 144 and 146 are secured to the substrate by mechanical interference in the manner described above. The conductors 144 and 146 are vertically displaced to provide a gap therebetween. An actuator 148 may be used to close the gap between the conductors 144 and 146 permitting electrical communication therebetween. In Fig. 7(c), a deformed portion of the conductor 150 is disposed in an aperture 152 in the substrate 14. The conductors 150 and 154 can then be located close to the surface of the substrate 14 thereby minimizing the vertical space occupied by the switch 132. In Fig. 7(d), a first conductor 156 includes a first portion 158 which is elevated from the second conductor 160. The actuator 148 may then be used to close the electrical circuit by depressing the deformed portion 158 on to the conductor 160. In Fig. 7(e), the two conductors 164 and 166 are secured in the manner described above. The portions 168 and 170 of the conductors 164 and 166 are bent by 90 degrees with respect to the unbent portion. Contact between the conductors 164 and 166 is then made by allowing the actuator 148 to force the bent portion 168 of the conductor 164 against the bent portion 170 of the conductor 166.

The apparatus 10 may also be used to form a heat sink 174 as shown in Fig. 8, in which a conductor 176 having a projection 178 is deposited and secured on the substrate 14 by mechanical interference in the manner described above. The electronic module 180 is then secured to the conductor 176 through a thermally conducted adhesive causing heat from the electronic module 180 to flow into the conductor 176. The heat generated by the electronic module 180 then flows into the conductor 176 and is dissipated into the environment through the projection 178. In this embodiment, the substrate 14 may be used to distribute power to the electronic module 180 through a second conductor 182 and the stake header 184.

The apparatus 10 may also be used in the formation of a terminal block 186 as shown in Figs. 9(a) and (b). The substrate 14 is formed having the retaining projections 188. The two conductors 190 and 192 are then formed and deposited on the substrate 14 in the manner described above. Two die cast retainers 194 and 196 are then inserted into the substrate 14 and are held in place by the retaining projections 188. The leads 198 from the cordset may then be inserted into the apertures 200 of the die cast retainers 194 and 196, whereupon the screws 202 are used to secure the leads 198 of the cordset. After the screws 202 have been tightened, the wires 204 of the cordset are disposed against the retaining projections 188.

The apparatus 10 may also be used to secure power cords to electrical units in the manner as shown in Figs. 10(a) and (b). The power cord 206 includes a strain relief portion 208 which mates with the housing 210 of the unit 212. The cord 206 further includes two leads 214 and 216 which are secured to a substrate 14 by molded conductor retainers 218 and 220 in the substrate 14. Attached to the unit 212 are two conductors 222 and 224 having conductor terminals 226 and 228 formed and secured in the manner described above. The conductors 222 and 224 act as a bus to distribute current to various components in the unit 212. Alternatively, the conductors 222 and 224 may electrically communicate with the barrel terminals 226 and 228 which allow for direct insertion of the leads 214 and 216 as shown in Fig. 10(b).

It will be appreciated from the above that methods are provided by the present invention by which power distribution systems and/or parts thereof can be automatically assembled.

It will also be appreciated that a power distribution system can be provided by the present invention that is reliable, relatively inexpensive, and simple to fabricate.

## Claims

1. A method of making at least a part of an electrical or electronical circuit, comprising the steps of locating a planar member (16) of electrically conducting material proximate a substrate (14) of electrically insulating material, and punching the planar member (16) to form a selected portion (12) therefrom, the punching step also being operable to effect interengagement between parts (40; 61, 62; 68; 72) of said selected portion (12) and the substrate (14), characterized in that:
said locating step comprises situating the planar member (16) between a punch (18) and a die plate (22) with the die plate (22) being disposed between the planar member (16) and the substrate (14);
said punching step includes passing said punch (18) through said planar member (16) and into said die plate (22) to punch said selected portion (12) from said planar member (16) and deposit said selected portion (12) through said die plate (22) onto said substrate (14) with said interengagement between said parts (40; 61, 62; 68; 72) occurring; and
said punching step also includes, subsequent to said interengagement between said parts (40; 61, 62; 68; 72) having occurred, mechanically deforming at least one (40; 61; 68; 72) of the previously interengaged parts to positively secure said parts (40; 61, 62; 68; 72) together.

2. The method of Claim 1, characterized in that said substrate (14) includes a projection (40) which engages through an aperture in said selected portion (12), said mechanically deforming being operable to cause deformation of said projection (40) over said aperture.

3. The method of Claim 1, characterized in that said interengagement includes the insertion of a region (61) of said selected portion (12) through an aperture (62) in said substrate (14).

4. The method of Claim 3, characterized in that said mechanically deforming is effected upon said region (61) of said selected portion (12) after said region (61) has been inserted through said aperture (62).

5. The method of Claim 1, characterized in that said substrate (14) has at least one rib (68), and said mechanical deforming is operable to deform said rib (68).

6. The method of Claim 1, characterized in that said step of punching said planar member (16) includes the steps of forming a lance (72) on said selected portion (12) and inserting said lance (72) into an aperture (74) in said substrate (14).

7. The method of Claim 6, characterized in that said mechanical deforming comprises forcing a portion of said lance (72) against a support (36) supporting said substrate (14) thereby causing said lance (72) to be deformed.

8. The method of any one of Claims 1 to 7, characterized in that said selected portion (12) is formed as an electrical component mounting (106; 222) secured to said substrate (14).

9. A terminal assembly for connecting at least one lead (110) from an electrical component (114) to a power distribution system, said terminal assembly being attached to a substrate (14) by the method of any one of Claims 1 to 7 and being characterized by:
an electrical conductor (12) having a grooved portion (106) operable to receive said lead (110);
said substrate (14) mechanically communicating with said electrical conductor (12); and
means for securing said electrical conductor (12) to said substrate (14), said securing means comprising a part of said substrate (14) and at least a part of said conductor (12) interengaged with mechanical interference therebetween.

10. A multilayer power distribution system, characterized by:
a first substrate layer (94);
a first conductor layer (96) mechanically communicating with said first substrate layer (94);
a second substrate layer (98) mechanically communicating with said first conductor layer (96);
a second conductor layer (12) having projections (104) extending through said second substrate layer (98), said projections (104) permitting electrical communication between said first conductor layer (96) and said second conductor layer (12); and
said second conductor layer (12) having been attached to said second substrate layer (98) by the method of Claim 1.

11. An electrical switch, characterized by:
a first electrical conductor (150) formed from a sheet of conductive material (16) during a punching operation;
a second electrical conductor (154) formed from said sheet of conductive material (16) during a punching operation and displaceable into contact with said first electrical conductor (150) to close said electrical switch;
a substrate (14) to which said first and second electrical conductors (150, 154) are attached; and
said electrical conductors (150, 154) being attached to said substrate (14) by the method of any one of Claims 1 to 7 with the formation of mechanical interengagement between said substrate (14) and each of said first and second electrical conductors (150, 154).

12. A heat sink of an electronic module, characterized by:
a thermally conductive member (176) being formed from a planar member (16) during a punching operation;
a substrate (14) mechanically communicating with said thermally conductive member (176);
means for attaching said conductive member (176) to said substrate (14) with mechanical interengagement between said thermally conductive member (176) and said substrate (14); and
said thermally conductive member (176) having been formed and attached to said substrate (14) by the method of Claim 1.

## Patentansprüche

1. Verfahren zum Herstellen von mindestens einem Teil eines elektrischen oder elektronischen Schaltkreises, mit den Schritten des Anordnens eines ebenen Bauteils (16) aus elektrisch leitendem Material in der Nähe eines Substrats (14) aus elektrisch isolierendem Material, und des Stanzens des ebenen Bauteils (16) zum Bilden eines ausgewählten Teilstücks (12) davon, wobei der Stanzschritt ebenfalls betriebsfähig ist, um einen gegenseitigen Eingriff zwischen Teilen (40; 61, 62; 68; 72) des ausgewählten Teilstücks (12) und des Substrats (14) zu bewirken, dadurch **gekennzeichnet,** daß
der Anordnungsschritt ein Positionieren des ebenen Bauteils (16) zwischen einem Stanzstempel (18) und einer Stempelplatte (22) enthält, wobei die Stempelplatte (22) zwischen dem ebenen Bauteil (16) und dem Substrat (14) liegt;
der Stanzschritt ein Hindurchführen des Stanzstempels (18) durch das ebene Bauteil (16) und in die Stempelplatte (22) einschließt, um das ausgewählte Teilstück (12) von dem ebenen Bauteil (16) zu stanzen und das ausgewählte Teilstück (12) durch die Stempelplatte (22) auf das Substrat (14) abzulegen, wobei der gegenseitige Eingriff zwischen den Teilen (40; 61, 62; 68; 72) stattfindet; und
der Stanzschritt folgend auf den gegenseitigen Eingriff zwischen den Teilen (40; 61, 62; 68; 72) auch ein mechanisches Deformieren an zumindest einem (40; 61; 68; 72) der vorher miteinander in Eingriff getretenen Teile einschließt, um die Teile (40; 61, 62; 68; 72) definitiv aneinander zu befestigen.

2. Verfahren nach Anspruch 1, dadurch **gekennzeichnet,** daß das Substrat (14) einen Vorspung (40) aufweist, der durch eine Öffnung in dem ausgewählten Teilstück (12) angreift, wobei das mechanische Deformieren betriebsfähig ist, um ein Deformieren des Vorsprungs (40) über der Öffnung zu bewirken.

3. Verfahren nach Anspruch 1, dadurch **gekennzeichnet,** daß der gegenseitige Eingriff die Einfügung eines Bereichs (61) des ausgewählten Teilstücks (12) durch eine Öffnung (62) in dem Substrat (14) einschließt.

4. Verfahren nach Anspruch 3, dadurch **gekennzeichnet,** daß das mechanische Deformieren auf den Bereich (61) des ausgewählten Teilstücks (12) bewirkt wird, nachdem der Bereich (61) durch die Öffnung (62) eingeführt worden ist.

5. Verfahren nach Anspruch 1, dadurch **gekennzeichnet,** daß das Substrat (14) mindestens eine Rippe (68) aufweist, und daß das mechanische Deformieren betriebsfähig ist, um die Rippe (68) zu deformieren.

6. Verfahren nach Anspruch 1, dadurch **gekennzeichnet,** daß der Schritt des Stanzens des ebenen Bauteils (16) die Schritte des Formens einer Lanze (72) auf dem ausgewählten Teilstück (12) und des Einsetzens der Lanze (72) in eine Öffnung (74) in dem Substrat (14) einschließt.

7. Verfahren nach Anspruch 6, dadurch **gekennzeichnet,** daß das mechanische Deformieren ein Drücken eines Teilstücks der Lanze (72) gegen eine Unterlage (36) einschließt, die das Substrat (14) hält, wodurch eine Deformation der Lanze (72) bewirkt wird.

8. Verfahren nach einem der Ansprüche 1 bis 7, dadurch **gekennzeichnet,** daß das ausgewählte Teilstück (12) als eine Montierung (106; 222) für elektrische Komponenten gebildet ist, die an dem Substrat (14) befestigt ist.

9. Anschlußanordnung zum Verbinden zumindest einer Leitung (110) von einer elektrischen Komponente (114) an ein Energieverteilungssystem, wobei die Anschlußanordnung an einem Substrat (14) durch das Verfahren nach einem der Ansprüche 1 bis 7 angebracht ist und gekennzeichnet ist durch:
einen elektrischen Leiter (12) mit einem gekerbten Teil (106), der zum Aufnehmen der Leitung (110) betriebsfähig ist;
wobei das Substrat (14) mechanisch mit dem elektrischen Leiter (12) in Verbindung steht; und
Mittel zum Befestigen des elektrischen Leiters (12) an dem Substrat (14), wobei die Befestigungsmittel einen Teil des Substrats (14) und wenigstens einen Teil des Leiters (12) aufweisen, die durch mechanischen Eingriff dazwischen angreifen.

10. Mehrschichtiges Energieverteilungssystem, **gekennzeichnet** durch:
eine erste Substratschicht (94);
eine erste Leiterschicht (96), die in mechanischer Verbindung mit der ersten Substratschicht (94) steht;
eine zweite Substratschicht (98); die in mechanischer Verbindung mit der ersten Leiterschicht (96) steht;
eine zweite Leiterschicht (12) mit Vorsprüngen (104), die sich durch die zweite Substratschicht (98) hindurch erstrecken, wobei die Vorsprünge (104) eine elektrische Verbindung zwischen der ersten Leiterschicht (96) und der zweiten Leiterschicht (12) gestatten; und dadurch, daß
die zweite Leiterschicht (12) an der zweiten Substratschicht (98) durch das Verfahren nach Anspruch 1 angebracht wurde.

11. Elektrischer Schalter, **gekennzeichnet** durch:
einen ersten elektrischen Leiter (150), der aus einer dünnen Platte aus leitendem Material (16) während eines Stanzvorgangs gebildet wird;
einen zweiten elektrischen Leiter (154), der aus der dünnen Platte aus leitendem Material (16) während eines Stanzvorganges gebildet wird und der mit dem ersten elektrischen Leiter (150) verschiebbar in Verbindung kommen kann, um den elektrischen Schalter zu schließen;
ein Substrat (14), an dem der erste und der zweite elektrische Leiter (150, 154) angebracht sind; und dadurch, daß
die elektrischen Leiter (150, 154) an dem Substrat (14) durch das Verfahren nach einem der Ansprüche 1 bis 7 mit der Bildung eines mechanischen Eingriffs zwischen dem Substrat (14) und jedem der ersten und zweiten elektrischen Leiter (150, 154) angebracht sind.

12. Kühlkörper eines elektronischen Moduls, **gekennzeichnet** durch:
ein thermisch leitendes Bauteil (176), das während eines Stanzvorganges von einem ebenen Bauteil (16) gebildet wird;
ein Substrat (14), das mechanisch mit dem thermisch leitenden Bauteil (176) in Verbindung steht;
Mittel zum Anbringen des leitenden Bauteils (176) an dem Substrat (14) unter mechanischem Eingriff zwischen dem thermisch leitenden Bauteil (176) und dem Substrat (14); und dadurch, daß
das thermisch leitende Bauteil (176) durch das Verfahren nach Anspruch 1 gebildet und an dem Substrat (14) angebracht wurde.

## Revendications

1. Procédé de production d'au moins une partie d'un circuit électrique ou électronique, comprenant les phases consistant à placer un élément plat (16) fait d'une matière conductrice de l'électricité à proximité d'un substrat (14) fait d'une matière isolante de l'électricité et à poinçonner l'élément plat (16) pour mettre en forme une portion choisie (12) de cet élément, la phase de poinçonnage ayant aussi pour effet de provoquer une mise en prise entre des parties (40; 61, 62; 68; 72) de ladite portion choisie (12) et le substrat, caractérisé en ce que :
ladite phase de positionnement consiste à placer l'élément plat (16) entre un poinçon (18) et une plaque matrice (22), la plaque matrice (22) étant disposée entre l'élément plat (16) et le substrat (14) ;
la dite phase de poinçonnage consiste à faire passer ledit poinçon (18) à travers l'élément plat (16) et à le faire pénétrer dans ladite plaque matrice (22) pour poinçonner ladite portion choisie (12) dans ledit élément plat (16) et déposer ladite portion sélectionnée (12) sur ledit substrat (14)à travers ladite plaque matrice (22) avec réalisation de ladite mise en prise mutuelle entre lesdites parties (40; 61, 62; 68; 72) ;
la dite phase de poinçonnage consiste aussi, après ladite mise en prise entre lesdites parties (40; 61, 62; 68; 72), à déformer mécaniquement au moins une (40; 61; 68; 72) des parties précédemment mises en prise pour fixer positivement lesdites parties (40; 61, 62; 68; 72) l'une à l'autre.

2. Procédé selon la revendication 1, caractérisé en ce que ledit substrat (14) comprend un tenon (40) qui est engagé à travers une ouverture de ladite portion choisie (12) ; ladite déformation mécanique ayant pour effet de provoquer la déformation dudit tenon (40) sur ladite ouverture.

3. Procédé selon la revendication 1, caractérisé en ce que ladite mise en prise comprend l'insertion d'une région (61) de ladite portion choisie (12) à travers une ouverture (62) dudit substrat.

4. Procédé selon la revendication 3, caractérisé en ce que ladite déformation mécanique s'effectue sur ladite région (61) de ladite portion choisie (12) après que ladite région (61) a été insérée à travers ladite ouverture (62).

5. Procédé selon la revendication 1, caractérisé en ce que ledit substrat (14) présente au moins une nervure (68), et ladite déformation mécanique a pour effet de déformer ladite nervure (68).

6. Procédé selon la revendication 1, caractérisé en ce que ladite phase de poinçonnage dudit élément plat (16) comprend les phases consistant à fomer une languette (72) sur ladite portion choisie (12) et à inserer ladite languette (72) dans une ouverture (74) dudit substrat (14).

7. Procédé selon la revendication 6, caractérisé en ce que ladite déformation mécanique consiste à presser une portion de ladite languette (72) à force contre un support (36) qui donne appui au substrat (14), en obligeant ainsi ladite languette (72) à se déformer.

8. Procédé selon une quelconque des revendications 1 à 7, caractérisé en ce que ladite portion choisie (12) est mise à la forme d'un support (106; 222) de composants électriques fixé audit substrat (14).

9. Ensemble de borne pour connecter au moins un conducteur (110) relié à un composant électronique (114) à un système de distribution d'électricité, ledit ensemble de borne étant fixé à un substrat (14) par le procédé selon l'une quelconque des revendications 1 à 7, et étant caractérisé par : un conducteur électrique (12) comprenant une portion rainurée (106) capable de recevoir ledit conducteur (110) ;
ledit substrat (14) étant en liaison mécanique avec ledit conducteur électrique (12) ; et
des moyens servant à fixer ledit conducteur électrique (12) audit substrat (14), lesdits moyens de fixation comprenant une partie dudit substrat (14) et au moins une partie dudit conducteur (12) qui sont en prise avec interférence mécanique entre eux.

10. Système de distribution d'électricité multicouche, caractérisé par :
une première couche (94) fomant substrat ;
une première couche conductrice (96) liée mécaniquement à ladite première couche (94) formant substrat ;
une seconde couche (98) formant substrat reliée mécaniquement à ladite première couche conductrice (96) ;
une seconde couche conductrice (12) présentant des saillies (104) qui s'étendent à travers ladite seconde couche (98) formant substrat, lesdites saillies (104) permettant une liaison électrique entre ladite première couche conductrice (96) et ladite seconde couche conductrice (12) ; et
ladite seconde couche conductrice (12) ayant été fixée à ladite seconde couche (98) formant substrat par le procédé de la revendication 1.

11. Interrupteur électrique, caractérisé par :
un premier conducteur électrique (150) formé à partir d'une feuille de matière conductrice (16) pendant une opération de poinçonnage ;
un second conducteur électrique (154) formé à patir de ladite feuille de matière conductrice (16) pendant une opération de poinçonnage et qui peut être mise en contact avec ledit premier conducteur électrique (150) pour fermer ledit interrupteur électrique ;
un substrat (14) auquel lesdits premier et second conducteurs électriques (150, 154) sont fixés ; et
lesdits conducteurs électriques (150, 154) étant fixés audit substrat (14) par le procédé de l'une quelconque des revendication de 1 à 7, avec formation d'une prise mécanique entre ledit substrat (14) et chacun desdits premier et second conducteurs électriques (150, 154).

12. Puits de chaleur de module électronique caractérisé par :
un élément conducteur de la chaleur (176) qui est formé à partir d'un élément plat (16) pendant une opération de poinçonnage ;
un substrat (14) qui est en liaison mécanique avec ledit élément conducteur de la chaleur (176) ;
des moyens servant à fixer ledit élément conducteur de la chaleur (176) audit substrat (14) avec prise mécanique entre ledit élément conducteur de la chaleur (176) et ledit substrat (14) ; et
ledit élément conducteur de la chaleur (176) ayant été fixé et formé audit substrat (14) par le procédé selon la revendication 1.
